# FASCICULE DE BREVET EUROPEEN

(11) **EP 2 157 603 B1**
(45) Date de publication et mention de la délivrance du brevet: **12.10.2011**
(21) Numéro de dépôt: 09168024.9
(22) Date de dépôt: 18.08.2009
(51) Int. Cl.: H01L 21/762

(54) **Procédé de réalisation de structures GeOI localisées, obtenues par enrichissement en germanium**
Verfahren zur Herstellung von lokalisierten GeOI-Strukturen, die durch Germanium-Anreicherung erhalten werden
Method for manufacturing localised GeOI structures, obtained by germanium enrichment

(30) Priorité: 22.08.2008 FR 0855671
(43) Date de publication de la demande: 24.02.2010
(73) Titulaire: Commissariat à l'Énergie Atomique et aux Énergies Alternatives, 75015 Paris (FR)
(72) Inventeur: Damlencourt, Jean-Francois, 38190, LAVAL (FR); Vincent, Benjamin, 38000, GRENOBLE (FR)
(74) Mandataire: Ilgart, Jean-Christophe

(56) Documents cités:
- EP-A- 1 801 854
- US-A1- 2005 056 352
- US-A1- 2005 221 591
- US-A1- 2006 042 542
- YIN HAIZHOU ET AL: "High-germanium-content SiGe islands formed on compliant oxide by SiGe oxidation" APPLIED PHYSICS LETTERS, AIP, AMERICAN INSTITUTE OF PHYSICS, MELVILLE, NY, vol. 84, no. 18, 3 mai 2004 (2004-05-03), pages 3624-3626, XP012061330 ISSN: 0003-6951
- NASSAU K ET AL.: "Modified phosphosilicate glasses for VLSI applications" JOURNAL OF THE ELECTROCHEMICAL SOCIETY, vol. 132, no. 2, février 1985 (1985-02), pages 409-415, XP008104318
- TAIZOH SADOH ET AL.: "Improvement of oxidation-induced Ge condensation method by H+ implantation and two-step annealing for highly stress-relaxed SiGe-on-Insulator" JAPANESE JOURNAL OF APPLIED PHYSICS, vol. 44, no. 4B, 21 avril 2005 (2005-04-21), pages 2357-2360, XP002521129

## Description

### DOMAINE TECHNIQUE

L'invention concerne un procédé de réalisation de structures GeOI localisées, obtenues par enrichissement en germanium.

### ÉTAT DE LA TECHNIQUE ANTÉRIEURE

La course aux performances (niveau de courant, vitesse, ...) en micro-électronique Silicium pousse à miniaturiser de plus en plus la taille des transistors (loi de MOORE). En parallèle de cette voie de miniaturisation, des approches d'introduction de nouveaux matériaux (par exemple des matériaux à forte mobilité comme le germanium) et de contraintes mécaniques (une contrainte en tension favorise le transport électronique alors qu'une contrainte en compression favorise le transport par trous) sont à l'étude.

Les éléments de base de la microélectronique C-MOS (« Complementary Metal Oxide Semiconductor ») sont le N-MOS (transistor à conduction par électrons) et le P-MOS (transistor à conduction par trous). Ces deux types de transistors sont associés pour réaliser des fonctions logiques (portes OR, AND, NOR, NAND, ...) ou des points mémoire (SRAM-6T par exemple). Aujourd'hui, la totalité des composants pour la microélectronique grand public sont faits sur des substrats de silicium.

Du fait du ratio des mobilités volumiques entre électrons et trous dans le silicium (respectivement 1500 et 500 cm²/V/s), les caractéristiques électriques des transistors N-MOS et P-MOS présentent des dissymétries et les P-MOS sont beaucoup moins performants (en terme de courant débité et donc de vitesse) que les N-MOS.

La co-intégration d'un N-MOS en silicium et d'un P-MOS en germanium sur un même substrat est un moyen d'améliorer les caractéristiques du P-MOS dans le circuit C-MOS mais aussi d'équilibrer les transistors N et P tant en terme de niveau de courant qu'en terme de constantes de temps et ceci sans perte de place. En effet, la mobilité volumique des trous dans le germanium est de l'ordre de 1900 cm²/V/s et celle des électrons dans le silicium est voisine de 1500 cm²/V/s, ce qui permet de fabriquer des transistors N et P de mêmes dimensions et ayant quasiment les mêmes caractéristiques électriques.

Toujours dans une optique d'amélioration des performances, on pourrait aussi penser utiliser le germanium pour les N-MOS car la mobilité volumique des électrons dans le germanium est voisine de 4000 cm²/V/s (contre 1500 cm²/V/s sur silicium). Mais, aujourd'hui, un phénomène physique non compris limite les performances des N-MOS sur germanium. A l'heure actuelle, les caractéristiques électriques des N-MOS germanium sont moins bonnes que celles des N-MOS silicium, d'où le peu d'intérêt actuel du N-MOS sur germanium (vu sa non-maturité) et le fort intérêt de la co-intégration Si/Ge.

En raison des fortes fuites électriques que présentent les composants à base de germanium (faible gap), ce matériau ne peut être logiquement utilisé que « posé » sur un isolant. Les substrats germanium-sur-isolant (ou GeOI) permettent ainsi de limiter les fuites par le substrat et améliorent grandement les caractéristiques des composants réalisés.

On sait réaliser des zones localisées de germanium sur isolant par la technique dite de l'enrichissement en germanium (appelée « germanium condensation » dans la terminologie anglo-saxonne). On peut se référer à ce sujet à l'article « A Novel Fabrication Technique of Ultrathin and Relaxed SiGe Buffer Layers with High Ge Fraction for Sub-100 nm Strained Silicon-on-Insulator MOSFETS » de T. TEZUKA et al., Jpn. J. Appl. Phys., vol. 40 (2001) 2866-2874.

La première étape de cette technique consiste en l'épitaxie d'une couche de SiGe sur un substrat Silicium-sur-Isolant (SOI). La concentration et l'épaisseur de la couche de SiGe épitaxiée sont préférentiellement choisies pour que la couche de SiGe soit dans un état de contrainte pseudomorphe. La deuxième étape est une oxydation sèche à haute température (supérieure à 900°C) permettant la formation exclusive de l'oxyde SiO₂ dû à une enthalpie de formation (négative) plus importante que celle du GeO₂. Au cours de l'oxydation, le germanium se trouve piégé entre deux barrières : l'interface avec l'oxyde enterré (BOX), fixe, et l'interface d'oxydation en mouvement. Dû à la haute température d'oxydation, le germanium diffuse dans la couche de SiGe délimitée par ces deux barrières, homogénéisant ainsi l'alliage SiGe. L'épaisseur du SiGe diminuant, la concentration en germanium s'enrichit durant l'oxydation, formant ainsi un substrat de silicium-germanium sur isolant (SGOI). La concentration de Ge peut atteindre 100% par cette technique pour la formation d'un substrat GeOI pur avec un temps d'oxydation adapté.

Un premier mode de mise en oeuvre consiste en un dépôt non sélectif de SiGe sur un substrat de silicium sur isolant et un masquage, à l'aide d'une couche imperméable à l'oxydation, des zones qu'on ne souhaite pas enrichir. L'enrichissement s'effectue donc sur les zones non masquées. Les zones masquées sont en nitrure de silicium. Une zone non masquée (par exemple une zone « canal » de transistor) s'enrichit en Ge durant l'oxydation alors que des zones masquées (par exemple des zones « source et drain » de transistor) sont en SiGe de faible concentration (diffusion du Ge de la couche de SiGe vers la couche de Si pour équilibrer les concentrations). Ce premier mode de réalisation est décrit dans le document FR-A-2 902 234 correspondant au document US 2007/284625. La figure 1 est une vue en coupe transversale illustrant ce mode de réalisation. Le substrat comprend un support en silicium 1 supportant successivement une couche d'oxyde enterré 2, une couche mince de silicium 3 et une couche de SiGe 4. La référence 5 représente un masque de Si₃N₄. L'enrichissement localisé s'effectue dans les zones non masquées (une seule est représentée). On obtient, dans les zones non masquées, une couche de SiGe enrichie en germanium, voire une couche de germanium, reposant sur la couche d'oxyde enterré et surmontée d'une couche d'oxyde de silicium.

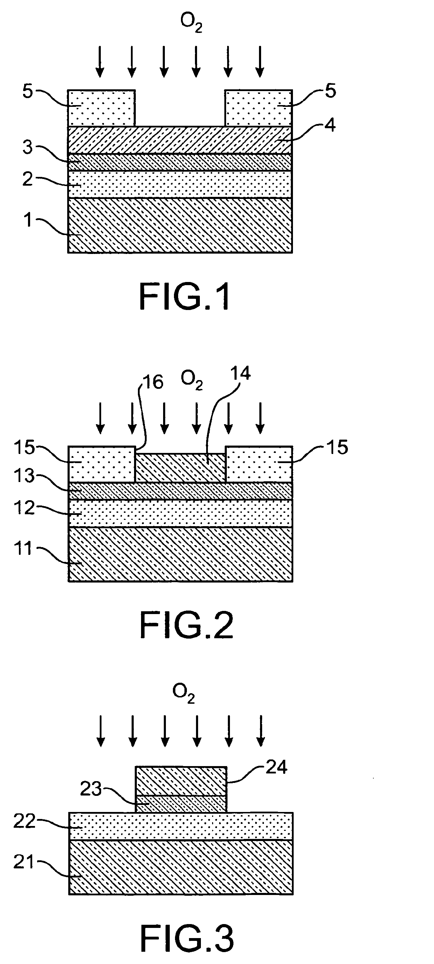

Un deuxième mode de mise en oeuvre consiste en un dépôt de SiGe sélectif dans des cavités pratiquées dans une couche en matériau imperméable à l'oxydation et définies sur un substrat SOI. La zone « canal » s'enrichit en germanium durant l'oxydation alors que les zones « source et drain » restent en silicium. La figure 2 est une vue en coupe transversale illustrant ce mode de réalisation. Le substrat comprend un support en silicium 11 supportant successivement une couche d'oxyde enterré 12, une couche mince de silicium 13 et une couche de nitrure de silicium 15. Des cavités 16 (une seule est représentée) sont réalisées dans la couche de nitrure 15 jusqu'à révéler la couche mince de silicium 13. Un dépôt de SiGe 14 est réalisé dans les cavités 16. L'enrichissement en germanium est alors réalisé. On obtient une couche de SiGe enrichie en germanium, voire une couche de germanium, reposant sur la couche d'oxyde enterré et surmontée d'une couche d'oxyde de silicium.

Un troisième mode de réalisation consiste en la définition de zones mesa à partir d'une couche de SiGe déposée de manière non sélective sur un substrat SOI. Les zones de SiGe sont ensuite enrichies. Les zones « canal » et « source et drain » sont dans ce cas enrichies en germanium, voire sont en germanium. La figure 3 est une vue en coupe transversale illustrant ce mode de réalisation. Le substrat comprend un support en silicium 21 supportant successivement une couche d'oxyde enterré 22, une couche mince de silicium 23 et une couche de SiGe 24. On définit des zones mesa à partir de la couche mince de silicium 23 et de la couche de SiGe 24. L'enrichissement en germanium est alors réalisé. On obtient une couche de SiGe enrichie en germanium, voire une couche de germanium, reposant sur la couche d'oxyde et surmontée d'une couche d'oxyde de silicium.

Ces modes de réalisation sont alors susceptibles de présenter des inconvénients. Pour les premier et deuxième modes de réalisation, on peut observer des becs d'oiseau (ou « bird's beaks » dans la terminologie anglo-saxonne), c'est-à-dire une variation de la concentration et de l'épaisseur du SiGe. Pour le troisième mode de réalisation, on peut observer une oxydation de la couche d'oxyde enterré, de type LOCOS, avec oxydation et enrichissement latéral.

Ces phénomènes d'enrichissement latéraux observés lors de l'enrichissement des mesas sont problématiques car ils conduisent à des inhomogénéités d'enrichissement sur le substrat en fonction de la taille des motifs. Un examen Raman de motifs de différentes tailles enrichis en germanium, réalisés sur un substrat de 200 mm, après une étape d'oxydation/enrichissement, révèle que le motif le plus petit est enrichi à 100% en germanium alors que le motif le plus grand n'est enrichi qu'à 73% au centre et présente une inhomogénéité importante. Cette inhomogénéité observée sur différents motifs s'étend sur quelques micromètres et ne peut pas être due qu'au seul phénomène d'enrichissement latéral. En effet, les longueurs de diffusion des atomes de Ge sont de l'ordre de quelques centaines de nanomètres alors que ces phénomènes s'étendent sur plusieurs micromètres.

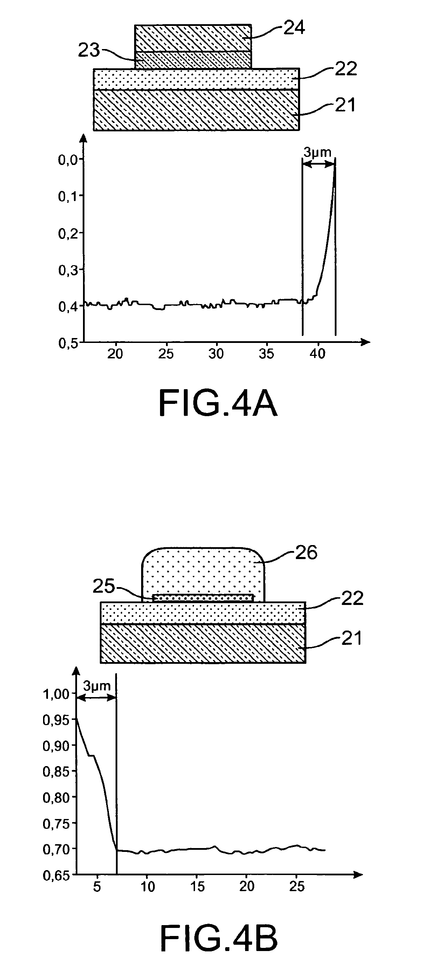

La figure 4A, qui reprend le troisième mode de réalisation, présente un spectre Raman d'une structure mesa après gravure et avant enrichissement où on distingue très clairement un gradient de contrainte aux bords du mesa. Ce phénomène est connu et est associé à la relaxation élastique en bords de marche de motifs. Cette relaxation s'étend sur une distance de 3 µm environ. Après enrichissement (voir la figure 4B), on constate une inhomogénéité de concentration de ce même mesa sur une distance équivalente à celle observée avant enrichissement. Sur la figure 4B, la référence 25 représente la couche de germanium obtenue, surmontée d'une couche d'oxyde de silicium 26. On peut en conclure que la relaxation élastique en bords de marche modifie la cinétique d'oxydation localement et de ce fait l'enrichissement final. Ce phénomène est problématique car son impact est différent selon la taille des motifs et entraînera des différences de concentration finale sur une plaque de 200 mm configurée selon les motifs présents.

EP-A-1 801 854 divulgue une structure semiconductrice comprenant un substrat, une couche d'oxyde de sicilium formée sur le substrat et contenant du germanium et une zone de SiGe formée au-dessus de la couche d'oxyde de silicium, la zone de SiGe étant relaxée et enrichie en Ge.

L'article « High-germanium-content SiGe islands formed on compliant oxide by SiGe oxidation" de Haizhou Yin et al., Applied Physics Letters, Vol.84, N°18, 3 mai 2004, pages 3624 à 3626, divulgue une structure semiconductrice comprenant un substrat, une couche d'oxyde de silicium de type BPSG formée sur le substrat et jouant le rôle de couche d'accommodation et une couche de SiGe relaxée, formée au-dessus de la couche d'oxyde de silicium et enrichie en germanium.

Il est connu par ailleurs de relaxer élastiquement les contraintes dans une couche d'oxyde de silicium dopé phosphore et bore (BPSG). Ce phénomène de relaxation des contraintes a déjà été étudié et a permis de réaliser des substrats compliants. On peut se référer à ce sujet à l'article « New Approach to Grow Pseudomorphic Structures over the Critical Thickness »

de Y.H. LO, Appl. Phys. Lett. 59 (18), pages 2311 à 2313, 28 octobre 1991.

L'article « Modified Phosphosilicate Glasses for VLSI Applications » de K. NASSAU et al., J. Electrochem. Soc. : Solid-State Science and Technology, Vol. 132, N°2, 1985, pages 409 à 415, décrit l'influence de dopants sur la température de fluage de certains oxydes. Le tableau 1 de ce document reproduit ci-dessous, montre l'influence sur la température de fluage (correspondant à une viscosité de 10¹³ poises) du dopage de l'oxyde de silicium par du phosphore, du bore et du germanium par rapport à de l'oxyde de silicium non dopé. Dans ce tableau, le symbole m/o représente le pourcentage molaire du composé par rapport à la composition du SiO₂ dopé.

| m/o P₂O₃ | m/o B₂O₃ | m/o GeO₂ | m/o SiO₂ | T_{g}(°C) |
|---|---|---|---|---|
| | | | 100,0 | 1160 |
| 8 | | | 92,0 | 725 |
| | 5,0 | | 95,0 | 815 |
| | 9,3 | | 90,7 | 700 |
| | 11,0 | | 89,0 | 685 |
| | 15,7 | | 84,3 | 540 |
| | 17,0 | | 83,0 | 535 |
| | | 4,1 | 95,9 | 800 |
| | | 7,0 | 93,0 | 750 |
| | | 13,3 | 86,7 | 730 |
| | | 13,5 | 86,5 | 725 |
| | | 31,0 | 69,0 | 650 |
| | | 45,0 | 55,0 | 660 |

Comme on peut le voir d'après ce tableau, si on dope de l'oxyde de silicium standard, il est possible d'abaisser sa température de fluage Tg. La température de fluage de l'oxyde de silicium non dopé est de 1160°C. Si on le dope avec 4,4.10²⁰ atomes/cm³ de bore (ce qui correspond à 5 m/o B₂O₃), la température de fluage est abaissée à 815°C. En dopant l'oxyde de silicium avec des atomes de germanium de 4,1 à 7 m/o GeO₂ on peut abaisser la température de fluage de 1160°C à respectivement 800°C et 750°C.

### EXPOSÉ DE L'INVENTION

La présente invention propose de surmonter les problèmes exposés ci-dessus en relaxant les contraintes élastiquement (sans création de défauts) en utilisant un oxyde fluant à basse température.

Il est donc proposé de réaliser un enrichissement en germanium localisé sur un oxyde fluant à basse température. En utilisant un tel oxyde, au lieu d'un oxyde SiO₂ standard, on évite l'emmagasinement de contraintes au fur et à mesure de l'enrichissement et on évite donc la création de défauts structuraux.

Le bore comme le phosphore peuvent, lors de l'enrichissement, diffuser dans la couche d'oxyde enrichie et devenir de ce fait un polluant. On propose donc de réaliser un GeOI localisé sur une couche de SiO₂ dopée Ge, qu'on pourrait appeler SOI compliant, qui permet lors de l'enrichissement progressif de relaxer les contraintes et donc d'obtenir un GeOI sans défauts structuraux. De plus, la relaxation de ces contraintes permet aussi de limiter les inhomogénéités d'oxydation observées. Selon l'invention, on réalise un dépôt de SiGe poreux avec une concentration en Ge de l'ordre de 1 à 45% en germanium et avantageusement de l'ordre du 4 à 13 m/o Ge. Le SiGe poreux peut être obtenu par attaque électrochimique d'une couche de SiGe monocristallin dopée bore ou phosphore dans une solution à base d'acide fluorhydrique.

L'invention a donc pour objet un procédé de réalisation d'au moins une structure GeOI par enrichissement en germanium d'une couche de SiGe supportée par une couche d'oxyde de silicium, caractérisé en ce que la couche d'oxyde de silicium est dopée par du germanium, le dopage de la couche d'oxyde du silicium par du germanium étant obtenu par oxydation d'une couche de SiGe poreux, la concentration en germanium dans la couche d'oxyde de silicium étant telle qu'elle abaisse la température de fluage de la couche d'oxyde de silicium en dessous de la température d'oxydation De la couche de SiGe réalisée pour permettre l'enrichissement en germanium de la couche de SiGe.

De préférence, la concentration en germanium dans la couche d'oxyde de silicium est telle que le pourcentage molaire de GeO₂ par rapport à la composition de la couche d'oxyde de silicium dopé est compris entre 4 et 13 m/o.

Avantageusement, la couche d'oxyde de silicium dopée par du germanium est obtenue par oxydation d'une couche de SiGe poreux.

Le procédé peut comprendre les étapes suivantes :
- formation de la couche initiale de SiGe monocristalline dopée sur un substrat support,
- formation de pores dans la couche initiale de SiGe dopée,
- formation d'une première couche de silicium monocristalline continue sur la couche de SiGe poreux,
- formation d'une couche de SiGe monocristalline destinée à être enrichie en germanium sur la couche de silicium,
- formation d'une deuxième couche de silicium monocristalline sur la couche de SiGe destinée à être enrichie en germanium,
- définition d'au moins un mesa dans l'empilement constitué par la première couche de silicium, la couche de SiGe destinée à être enrichie en germanium et la deuxième couche de silicium,
- dépôt d'espaceurs de protection sur les flancs du mesa,
- oxydation de la couche de SiGe poreux pour obtenir la couche d'oxyde de silicium dopée par du germanium,
- enrichissement en germanium de la couche de SiGe destinée à être enrichie en germanium.

La structure semiconductrice permettant de mettre en oeuvre le procédé selon l'invention comprend:
- un substrat,
- une couche d'oxyde de silicium formée sur le substrat,
- une zone de SiGe formée au-dessus de la couche d'oxyde de silicium,
caractérisée en ce que la couche d'oxyde de silicium est une couche dopée par du germanium, la concentration en germanium dans la couche d'oxyde de silicium étant telle qu'elle abaisse la température de fluage de la couche d'oxyde de silicium en dessous de la température d'oxydation permettant l'enrichissement en germanium de la zone en SiGe.

Selon un mode de réalisation préféré, la zone de SiGe fait partie d'un mesa comprenant une première couche de silicium intercalée entre la couche d'oxyde de silicium dopée par du germanium et la zone de SiGe, le mesa comprenant également une deuxième couche de silicium sur la zone de SiGe.

Les flancs du mesa peuvent être recouverts par des espaceurs de protection, par exemple en nitrure de silicium.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1, déjà décrite, illustre un premier mode de mise en oeuvre de la technique d'enrichissement localisé en germanium,
- la figure 2, déjà décrite, illustre un deuxième mode de mise en oeuvre de la technique d'enrichissement localisé en germanium,
- la figure 3, déjà décrite, illustre un troisième mode de mise en oeuvre de la technique d'enrichissement localisé en germanium,
- les figures 4A et 4B, déjà décrites, présentent des spectres Raman d'une structure mesa après gravure, respectivement avant enrichissement et après enrichissement,
- les figures 5A à 5F sont des vues en coupe transversale illustrant le procédé de réalisation de structures GeOI localisées, obtenues par enrichissement en germanium.

### EXPOSÉ DÉTAILLÉ D'UN MODE DE RÉALISATION PARTICULIER

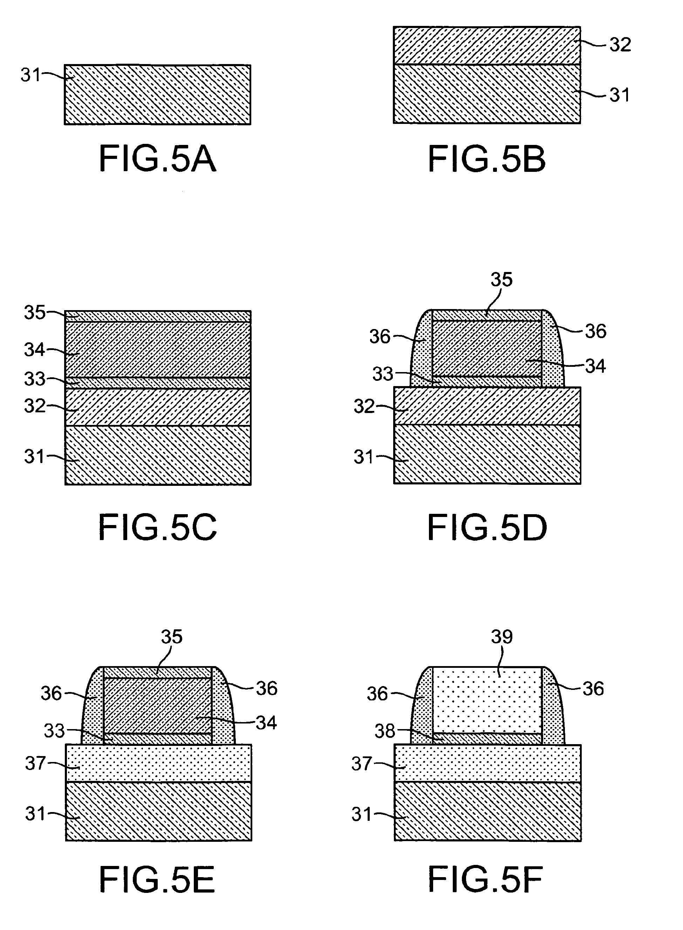

On va maintenant décrire un mode de réalisation particulier de l'invention. Ce mode de réalisation est illustré par les figures 5A à 5F qui sont des vues en coupe transversale.

La figure 5A représente un substrat 31 en silicium servant de support pour réaliser le procédé selon la présente invention.

Sur le substrat 31, on forme par épitaxie, selon une méthode connue de l'homme de l'art, une couche 32 de SiₓGe₁₋ₓ monocristallin dopée bore ou phosphore présentant une concentration en germanium telle que l'on ait, dans l'oxyde de silicium qui sera ensuite formé, une concentration en germanium correspondant de 4 à 7 m/o GeO₂ (voir la figure 5B).

La couche 32 de SiGe est rendue poreuse par attaque électrochimique dans une solution d'acide fluorhydrique. Le passage d'un courant continu pendant un certain laps de temps (de quelques secondes à quelques dizaines de minutes selon l'épaisseur de la couche poreuse voulue, le taux de dopage de la couche de SiGe et la nature du dopant utilisé) donne lieu à l'attaque du SiGe dopé en profondeur et à la formation sous la surface libre de la couche 32 d'une couche homogène de matériau poreux dont la porosité (pourcentage volumique de trous) peut atteindre 90%. La porosité et l'épaisseur de SiGe poreux formé augmente en fonction de la densité de courant mais dépend aussi du dopage de la couche de SiGe, de la concentration de HF ainsi que d'autres paramètres. On peut ainsi obtenir des couches de SiGe poreux de différentes épaisseurs (de 1 nm à quelques centaines de nm) et obtenir, après oxydation, des oxydes enterrés de différentes épaisseurs (BOX fin à BOX épais). De manière avantageuse, on peut choisir, vis-à-vis du compromis épaisseur barrière au fuite, une couche SiGe poreux de 145 nm.

Concernant l'influence du type de dopage, du taux de dopage et du courant électrique utilisé sur la morphologie et la taille des pores obtenus dans le silicium monocristallin, on peut se référer à l'article « Porous silicon formation mechanisms » de R.L. SMITH et al., J. Appl. Phys. 71(8), R1-R22, 15 avril 1992.

C. FENOUILLET-BERANGER et al. dans l'article « Requirements for ultra-thin-film devices and new materials for the CMOS roadmap », Solid-State Electronics 48 (2004), pages 961 à 967 décrivent l'influence de l'épaisseur d'une couche d'oxyde enterrée sur les effets canaux courts. Ce que l'on appelle « effets canaux courts », c'est tout paramètre qui dégrade le contrôle électrostatique de la grille, engendrant une diminution des performances d'un transistor, par exemple la tension de seuil (Vₜₕ), le courant off (I_{off}), etc.

Sur la couche 32 de SiGe poreux, on dépose par épitaxie, selon une méthode connue de l'homme de l'art, une couche de silicium monocristallin 33 de quelques nm d'épaisseur (voir la figure 5C). Cette couche servira aussi de masque lors de l'oxydation de la couche de SiGe poreux 32. La couche de silicium monocristallin 33 est déposée de manière continue sur la couche de SiGe poreux 32 et permet ensuite la croissance d'une couche de SiₓGe₁₋ₓ monocristallin 34 nécessaire à l'enrichissement en germanium (voir la figure 5C).

Sur la couche de SiₓGe₁₋ₓ 34 on forme ensuite par épitaxie une fine couche 35 de silicium de quelques nm d'épaisseur, idéalement 2 nm (voir la figure 5C).

Les zones qui seront ensuite des zones de germanium localisées sont définies par un procédé de lithogravure. La figure 5D montre, par souci de simplicité, une seule de ces zones. L'empilement des couches 33 de silicium, 34 de SiₓGe₁₋ₓ et 35 de silicium est gravé au moyen d'une gravure plasma avec arrêt sur la couche de SiGe poreux 32. Des espaceurs 36 en matériau diélectrique sont ensuite déposés sur les flancs de la structure gravée. Ces espaceurs sont par exemple en nitrure de silicium. Ils servent à protéger les flancs de la structure.

La couche de SiGe poreux 32 ainsi révélée sera le chemin de départ de l'oxydation de cette couche 32 pour obtenir une couche de SiO₂ dopée Ge. La température d'oxydation peut être comprise entre 400°C et 700°C, idéalement 600°C. En raison des différences de vitesse d'oxydation du SiGe poreux et de la couche de silicium monocristallin 33, la couche de silicium 33 sert de couche d'arrêt à l'oxydation. On obtient une couche 37 de SiO₂ dopée Ge (voir la figure 5E).

On peut ensuite réaliser l'enrichissement en germanium en utilisant le procédé connu de l'homme de l'art : oxydation sèche à une température supérieure à 900°C. Cette température est supérieure à la température de fluage de la couche 37 de SiO₂ dopé Ge. On obtient alors sur la couche 37 une couche 38 de SiGe enrichie en germanium, voire une couche de germanium. La couche 38 est alors surmontée d'une couche 39 en oxyde de silicium.

## Revendications

1. Procédé de réalisation d'au moins une structure GeOI par enrichissement en germanium d'une couche de SiGe (34) supportée par une couche d'oxyde de silicium (37), **caractérisé en ce que** la couche d'oxyde de silicium (37) est dopée par du germanium, le dopage de la couche d'oxyde de silicium par du germanium étant obtenu par oxydation d'une couche de SiGe poreux (32), la concentration en germanium dans la couche d'oxyde de silicium (37) étant telle qu'elle abaisse la température de fluage de la couche d'oxyde de silicium en dessous de la température d'oxydation de la couche de SiGe (34), ladite oxydation étant réalisée pour permettre l'enrichissement en germanium de la couche de SiGe (34).

2. Procédé selon la revendication 1, dans lequel la concentration en germanium dans la couche d'oxyde de silicium (37) est telle que le pourcentage molaire de GeO₂ par rapport à la composition de la couche d'oxyde de silicium dopé est compris entre 4 et 13 m/o.

3. Procédé selon l'une des revendications 1 ou 2, dans lequel la couche de SiGe poreux est obtenue par attaque électrochimique d'une couche initiale de SiGe dopée dans une solution d'acide fluorhydrique.

4. Procédé selon l'une quelconque des revendications 1 à 3, comprenant les étapes suivantes :
- formation de la couche initiale de SiGe monocristalline dopée (32) sur un substrat support (31),
- formation de pores dans la couche initiale de SiGe dopée (32),
- formation d'une première couche de silicium monocristalline continue (33) sur la couche de SiGe poreux (32),
- formation d'une couche de SiGe monocristalline (34) destinée à être enrichie en germanium sur la couche de silicium (33),
- formation d'une deuxième couche de silicium monocristalline (35) sur la couche de SiGe (34) destinée à être enrichie en germanium,
- définition d'au moins un mesa dans l'empilement constitué par la première couche de silicium (33), la couche de SiGe (34) destinée à être enrichie en germanium et la deuxième couche de silicium (35),
- dépôt d'espaceurs de protection (36) sur les flancs du mesa,
- oxydation de la couche de SiGe poreux (32) pour obtenir la couche d'oxyde de silicium dopée par du germanium (37),
- enrichissement en germanium de la couche de SiGe (34) destinée à être enrichie en germanium.

5. Procédé selon la revendication 4, dans lequel les espaceurs de protection (36) sont en nitrure de silicium.

## Claims

1. A method for making at least one GeOI structure by germanium condensation of a SiGe layer (34) supported by a layer of silicon oxide (37), **characterised in that** the layer of silicon oxide (37) is doped with germanium, the doping of the layer of silicon oxide by the germanium being obtained by oxidation of a porous SiGe layer (32), the concentration of germanium in the layer of silicon oxide (37) being such that it lowers the flow temperature of the layer of silicon oxide below the oxidation temperature of the SiGe layer (34), said oxidation being realized to allow germanium condensation of the SiGe layer (34).

2. The method as claimed in Claim 1, in which the concentration of germanium in the layer of silicon oxide (37) is such that the molar percentage of GeO₂ relative to the composition of the doped layer of silicon oxide is between 4 and 13 m/o.

3. The method as claimed in Claims 1 or 2, in which the porous SiGe layer is obtained by electrochemical attack of an initial layer of doped SiGe in a solution of hydrofluoric acid.

4. The method as claimed in any one of Claims 1 to 3, comprising the following steps:
- formation of the initial layer of doped monocrystalline SiGe (32) on a support substrate (31),
- formation of pores in the initial layer of doped SiGe (32),
- formation of a first continuous monocrystalline silicon layer (33) on the porous SiGe layer (32),
- formation of a monocrystalline SiGe layer (34) intended to be enriched with germanium on the silicon layer (33),
- formation of a second monocrystalline silicon layer (35) on the SiGe layer (34) intended to be enriched with germanium,
- definition of at least one mesa in the stack constituted by the first silicon layer (33), the SiGe layer (34) intended to be enriched with germanium and the second silicon layer (35),
- depositing protective spacers (36) on the flanks of the mesa,
- oxidation of the porous SiGe layer (32) to create the layer of silicon oxide doped with germanium (37),
- germanium condensation of the SiGe layer (34) intended to be enriched with germanium.

5. The method as claimed in Claim 4, in which the protective spacers (36) are made of silicon nitride.

## Patentansprüche

1. Verfahren zur Herstellung wenigstens einer GeOI-Struktur (Germanium-on-insulator, Germanium-auf-Isolator) mittels Germanium-Anreicherung einer auf einer Siliziumoxydschicht (37) getragenen SiGe- Schicht (34), **dadurch gekennzeichnet, dass** die Siliziumoxydschicht (37) mit Germanium dotiert ist, wobei die Dotierung der Siliziumoxydschicht mit Germanium mittels Oxydation einer porösen SiGe-Schicht (32) erhalten wird und die Germaniumkonzentration in der Siliziumoxydschicht (37) solcher Art ist, dass sie die Kriech- bzw. Fließtemperatur der Siliziumoxydschicht unter die Oxydationstemperatur der SiGe-Schicht (34) absenkt, wobei die Oxydation vorgenommen wird, um die Germanium-Anreicherung der SiGe-Schicht zu ermöglichen.

2. Verfahren nach Anspruch 1, bei welchem die Germaniumkonzentration in der Siliziumoxydschicht (37) solcher Art ist, dass der molare Prozentgehalt (die prozentuale Molarität) an GeO2 bezogen auf die Zusammensetzung der dotierten Siliziumoxydschicht zwischen 4 und 13 m/o (Molprozent) beträgt.

3. Verfahren nach einem der Ansprüche 1 oder 2, bei welchem die poröse SiGe-Schicht mittels elektrochemischer Einwirkung auf eine anfängliche dotierte SiGe-Schicht in einer Fluorwasserstoff-Säurelösung erhalten wird.

4. Verfahren nach einem beliebigen der Ansprüche 1 bis 3 , welches die folgenden Verfahrensstufen bzw. Etappen umfasst:
- Ausbilden der anfänglichen dotierten monokristallinen SiGe-Schicht (32) auf einem Trägersubstrat (31),
- Ausbilden von Poren in der anfänglichen dotierten SiGe-Schicht (32),
- Ausbilden einer ersten kontinuierlichen monokristallinen Siliziumschicht (33) auf der porösen SiGe-Schicht (32),
- Ausbilden einer zur Anreicherung mit Germanium betsimmten monokristallinen Siliziumschicht (33),
- Ausbilden einer zweiten monokristallinen Siliziumschicht (35) auf der zur Anreicherung mit Germanium bestimmten SiGe-Schicht (34),
- Festlegen wenigstens eines Mesa in dem aus der ersten Siliziumschicht (33), der zur Anreicherung mit Germanium bestimmten SiGe-Schicht (34) und der zweiten Siliziumschicht (35) gebildeten Schichtstapel,
- Abscheidung von Schutz-Abstandshaltern (36) auf den Flanken des Mesa,
- Oxydation der porösen SiGe-Schicht zum Erhält der mit Germanium dotierten Siliziumschicht (37),
- Anreichern der zur Germaniumanreicherung bestimmten SiGe-Schicht (34) mit Germanium.

5. Verfahren nach Anspruch 4, bei welchem die Schutz-Abstandshalter (36) aus Siliziumnitrid bestehen.
